(19) Europäisches Patentamt
European Patent Office
Office européen des brevets

(11) EP 0 480 287 B1

(12) **EUROPÄISCHE PATENTSCHRIFT**

(45) Veröffentlichungstag und Bekanntmachung des Hinweises auf die Patenterteilung:
**15.01.1997 Patentblatt 1997/03**

(51) Int Cl.[6]: **G03F 7/38**, G03F 7/039

(21) Anmeldenummer: **91116740.1**

(22) Anmeldetag: **01.10.1991**

(54) **Verfahren zur Herstellung von Reliefmustern und Reliefbildern**

Process for the production of relief patterns and relief images

Procédé de production des motifs et des images en relief

(84) Benannte Vertragsstaaten:
**BE DE FR GB IT NL**

(30) Priorität: **10.10.1990 DE 4032161**

(43) Veröffentlichungstag der Anmeldung:
**15.04.1992 Patentblatt 1992/16**

(73) Patentinhaber: **BASF Aktiengesellschaft**
**67063 Ludwigshafen (DE)**

(72) Erfinder:
- **Schwalm, Reinhold, Dr.**
  **W-6706 Wachenheim (DE)**
- **Binder, Horst**
  **W-6840 Lampertheim (DE)**

(56) Entgegenhaltungen:
**EP-A- 0 342 494** **DE-A- 3 721 741**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 480 287 B1

## Beschreibung

Die Erfindung betrifft ein Verfahren zur Herstellung von Reliefmustern und Reliefbildern unter Verwendung von positiv arbeitenden lichtempfindlichen Beschichtungsmaterialien, welche ein in wäßrig-alkalischen Lösungen lösliches Bindemittel und eine organische Verbindung enthalten, die mindestens eine durch Säure spaltbare Bindung enthält und unter Einwirkung von Strahlung eine starke Säure bildet, wobei die Löslichkeit dieser organischen Verbindung in wäßrig-alkalischen Lösungsmitteln durch die Einwirkung der Säure erhöht wird. Bei dem erfindungsgemäßen Verfahren beschichtet man ein Substrat mit diesen lichtempfindlichen Materialien, bestrahlt diese Schicht in einem gewünschten Muster, heizt anschließend aus und entwickelt mit alkalischen Lösungen.

Positiv arbeitende strahlungsempfindliche Gemische sind bekannt. Positiv arbeitende Resistmaterialien, die o-Chinondiazide in wäßrig alkalischen Bindemitteln, z.B. Novolake enthalten, werden kommerziell als Photoresiste eingesetzt, so daß auch die Verfahren zur Herstellung von Reliefbildern bekannt sind. Die Empfindlichkeit dieser Systeme gegenüber Strahlung ist jedoch teilweise unbefriedigend.

Daher hat man strahlungsempfindliche Systeme entwickelt, welche in der Primärphotoreaktion eine Spezies erzeugen, die dann unabhängig von der Strahlung eine katalytische Sekundärreaktion auslösen und dadurch die Empfindlichkeit drastisch erhöhen. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.

Weiterhin werden in der DE-A 3 721 741 strahlungsempfindliche Gemische vorgeschlagen, die ein in wäßrig-alkalischen Lösungen lösliches polymeres Bindemittel enthalten sowie eine organische Verbindung, deren Löslichkeit in einem wäßrig alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Ein Nachteil dieser Systeme ist deren Empfindlichkeit gegenüber Kontaminationen, welche den photochemisch erzeugten Katalysator desaktivieren. Solche Desaktivierungsreaktionen spielen besonders in Lagerzeiten zwischen dem Verfahrensschritt Belichtung und dem darauf folgenden Prozeß der Sekundärreaktion zur Abspaltung der säurelabilen Gruppen, meist durch Ausheizen unterstützt, eine entscheidende Rolle.

Aufgabe der vorliegenden Erfindung war es, Verfahren aufzuzeigen, mit denen man Photoresiste auf Basis säurekatalytischer Reaktionen, insbesondere lichtempfindlicher positiv arbeitender Beschichtungsmaterialien, bestehend aus in wäßrig-alkalischen Lösungen löslichem Bindemittel und einer organischen Verbindung, die mindestens eine durch Säure spaltbare Gruppierung und eine unter Einwirkung von Strahlung eine starke Säure bildende Gruppierung enthält, zu Reliefmustern verarbeiten kann, wobei ein praxisgerechter Verarbeitungsspielraum, insbesondere in bezug auf Lagerzeiten zwischen Belichtung und Ausheizschritten, ermöglicht wird.

Diese Aufgabe läßt sich durch das erfindungsgemäße Verfahren sehr vorteilhaft lösen.

Durch das erfindungsgemäße Verfahren lassen sich die Verfahrensschritte bei auftretenden Lagerzeiten unter Bedingungen durchführen, unter denen das Eindringen von Wasser und/oder anderen Nucleophilen in die Schicht reduziert oder ganz vermieden wird.

Gegenstand der vorliegenden Erfindung ist ein Verfahren zur Herstellung von Reliefmustern und Reliefbildern, bei dem man ein lichtempfindliches Beschichtungsmaterial, welches ein strahlungsempfindliches Gemisch, das

a) ein in Wasser unlösliches, in wäßrig-alkalischen Lösungen lösliches oder zumindest dispergierbares Bindemittel und

b) eine organische Verbindung, deren Löslichkeit in einem wäßrigalkalischen Entwickler durch Einwirkung von Säure erhöht wird und die mindestens eine durch Säure spaltbare Gruppierung, sowie zusätzlich eine weitere Gruppierung, die unter der Einwirkung von Strahlung eine starke Säure erzeugt, enthält,

auf ein Substrat aufbringt, das lichtempfindliche Material in einem gewünschten Muster mit elektromagnetischer Strahlung bildmäßig belichtet, nach der Belichtung bei Temperaturen zwischen 60°C und 120°C ausheizt, und anschließend das Muster mit einem basischen Entwickler entwickelt, das dadurch gekennzeichnet ist, daß zwischen Belichtung und Ausheizen nach der Belichtung das Eindringen von Wasser und/oder anderer Nucleophile in die Schicht reduziert oder vermieden wird, indem man sie nach der Belichtung in einer Atmosphäre geringer Luftfeuchtigkeit, im Vakuum oder unter Inertgas lagert.

Bevorzugt sind strahlungsempfindliche Gemische mit polymeren Bindemitteln (a) auf Basis von Homo- oder Copolymeren des p-Hydroxistyrols und/oder p-Hydroxi-methylstyrols. Als Comonomereinheiten kommen dabei besonders in o-Stellung mono- oder disubstituierte Hydroxistyrole oder Hydroxistyrole, deren phenolische Gruppe mit säurelabilen Gruppierungen geschützt ist, in Frage.

Bevorzugt sind solche organischen Verbindungen (b) die als durch Säure spaltbare Gruppierungen t-Butylcarbonat-, t-Amylcarbonat- oder t-Butylestergruppierungen enthalten.

Bevorzugt als organische Verbindungen (b) sind Sulfoniumsalze der allgemeinen Formel (I)

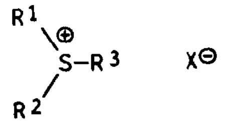

(I)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung enthält, wobei einer der Reste $R^1$ bis $R^3$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

Es können auch zwei oder mehrere Sulfoniumeinheiten im Molekül über die Reste $R^1$ bis $R^3$ verknüpft sein. Die organischen Verbindungen (b) werden im allgemeinen in Mengen von 2 bis 15, bevorzugt 3 bis 10 Gew.%, bezogen auf die Gesamtmenge des strahlungsempfindlichen Gemisches, eingesetzt.

Bevorzugte Sulfoniumsalze der allgemeinen Formel (I)

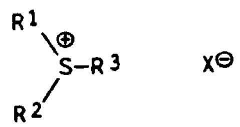

(I)

sind solche, in denen $R^1$ und $R^2$ für Methylgruppen und $R^3$ für substituierte Phenylderivate mit säurespaltbaren Gruppen stehen.

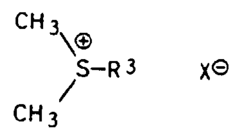

worin $R^3$ z.B. für 4-t-Butoxicarbonyloxi-phenyl-, 4-t-Butoxicarbonyloxi-3,5-dimethyl-phenyl-, 4-t-Butoxicarbonyloxi-3-methyl-phenyl-, 4-t-Butoxicarbonyloxi-2-methyl-phenyl-, 4-t-Butoxicarbonyloxi-3,5-dimethoxi-phenyl-, 4-t-Butoxicarbonyloxi-3,5-diphenyl-phenyl-, 1-t-Butoxicarbonyloxinaphthyl-, 4-Trimethylsilyl-oxi-phenyl-, 4-Trimethylsilyl-oxi-naphthylstehen oder auch solche, in denen zwei der Reste R1 bis R3 miteinander zu einem Ring, insbesondere einem fünf- oder sechsgliedrigen Ring verknüpft sind, wobei z.B. $R^1$ und $R^2$ beispielsweise zu Tetramethylengruppen verbrückt sind und $R^3$ die gleiche Bedeutung wie vorstehend hat:

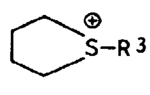

oder Verbindungen, in denen $R^1$ für Methyl und $R^2$ für Phenyl bzw. Tolyl stehen und $R^3$ für ein substituiertes Phenylderivat mit säurespaltbaren Gruppen steht, wie

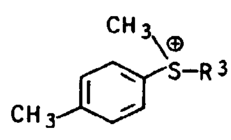

worin $R^3$ für 4-t-Butoxicarbonyloxi-phenyl-, 2,4-Di-t-butoxicarbonyloxiphenyl-, 4-t-Butoxicarbonyloxi-2-methoxi-phenyl-, 4-Trimethylsilylphenyl-steht,

oder worin $R^1$ für Phenyl oder $C_1$- bis $C_{12}$-alkylsubstituiertes Phenyl oder halogensubstituiertes Phenyl steht und $R^2$

und $R^3$ substituierte Phenylderivate mit säurespaltbaren Gruppen sind, wie z.B.

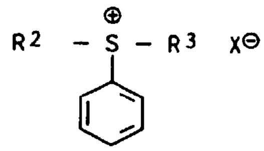

worin $R^2$ und $R^3$ z.B. 4-t-Butoxicarbonyloxi-phenyl, 4-Trimethylsilyloxiphenyl-, 4-t-Butyl-dimethyl-silyloxi-phenyl-, 4-t-Butoxicarbonyloxi-3,5-dimethyl-phenyl- oder $R^1$, $R^2$ und $R^3$ untereinander gleich sind, d.h. Sulfoniumsalze (b), in denen diese Reste mit säurespaltbaren Gruppen dreimal enthalten sind.

Weiterhin kommen auch Verbindungen der allgemeinen Formel (I) in Betracht, worin einer der Reste $R^1$ bis $R^3$ mit einem oder mehreren weiteren Sulfoniumsalzresten, gegebenenfalls über durch Säure spaltbare Gruppierungen verknüpft ist, die also ebenfalls mehrere Sulfoniumgruppen im Molekül aufweisen, wie z.B.

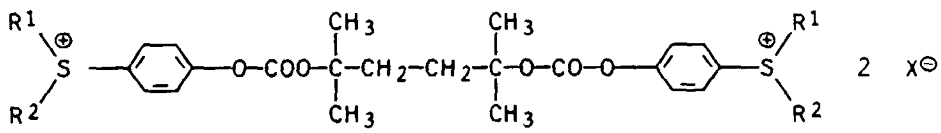

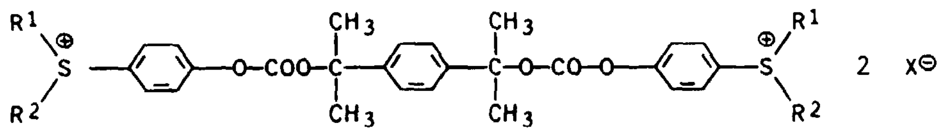

Als Gegenionen kommen bevorzugt komplexe Metallhalogenide, wie Tetrafluoroborat, Hexafluoroantimonat, Hexafluoroarsenat, Hexafluorophosphat und Trifluormethansulfonat in Betracht.

Mit diesen Systemen lassen sich sehr gute Resistmuster herstellen, wenn man die Prozeßschritte, insbesondere das thermische Ausheizen nach der Belichtung rasch nacheinander durchführt. In der Praxis können allerdings Wartezeiten zwischen den einzelnen Prozeßschritten auftreten. Erfindungsgemäß hat sich nun gezeigt, daß die Lagerung, insbesondere im Schritt nach der Belichtung und vor dem Ausheizen besonders vorteilhaft unter Bedingungen durchgeführt werden sollte, unter denen die Aufnahme von Wasser oder anderen Nucleophilen, insbesondere Aminen, reduziert bzw. ganz vermieden wird. In der Praxis wird bisher bei der Resistverarbeitung in Reinräumen gearbeitet, in denen die relative Luftfeuchtigkeit zwischen 45 % und 50 % liegt. Erfindungsgemäß hat es sich als besonders vorteilhaft herausgestellt, unter relativer Luftfeuchte von < 40 % oder unter Inertgas oder im Vakuum zu arbeiten.

Unter einer Atmosphäre geringer Luftfeuchtigkeit wird eine Atmosphäre mit relativer Luftfeuchte < 45 % vorzugsweise < 40 %, verstanden.

Unter Vakuum im Sinne der Erfindung wird verminderter Druck von 20 bis 0,1 Torr verstanden.

Als Inertgase eignen sich die üblichen, vorzugsweise Edelgase, wie z.B. Helium oder Argon sowie Stickstoff und Kohlendioxid, die jeweils nach bekannten üblichen Verfahren getrocknet sind.

Weitere Angaben über die Zusammensetzung derartiger strahlungsempfindlicher Gemische und deren Weiterverarbeitung sind beispielsweise der DE-A-37 21 741 zu entnehmen.

Die in den Beispielen und Vergleichsbeispielen genannten Teile und Prozente beziehen sich, soweit nicht anders angegeben, auf das Gewicht.

Beispiel 1

Eine Photoresistlösung wird aus 15 Teilen Phenyl-bis-(4-t-butoxicarbonyloxiphenyl)sulfonium-trifluoromethansulfonat, 85 Teilen Poly-(p-vinylphenol) vom mittleren Molekulargewicht $\overline{M}_w$ (GPC) 12000 g/mol und 300 Teilen Methoxipropylacetat hergestellt. Die Lösung wird anschließend durch ein Filter mit einem Porendurchmesser von 0,2 µm filtriert.

Diese Resistlösung wird auf einen oberflächlich oxidierten Siliziumwafer in einer Schichtdicke von ca. 1 µm aufgebracht und 1 Minute bei 100°C auf einer Heizplatte ausgeheizt. Dann belichtet man bildmäßig durch eine strukturierte

Testmaske im Kontaktverfahren während 4 Sekunden mit Excimer-Laserlicht der Wellenlänge 248 nm.

Danach lagert man den belichteten Wafer 4 Stunden im Vakuum (1 Torr), heizt anschließend 60 Sekunden bei 80°C aus und entwickelt mit einem alkalischen Entwickler vom pH-Wert 13,00 60 Sekunden lang. Die belichteten Bereiche sind vollständig abgetragen, während nur ein sehr geringer (2 %) Abtrag der unbelichteten Bereiche gemessen wird. Es entstehen Resistmuster guter Qualität mit vertikalen Flanken. Es werden keine unerwünschten Resistrückstände auf dem Wafer beobachtet.

Vergleichsbeispiel 1

Es wird wie in Beispiel 1 verfahren, jedoch wird nach der Belichtung 1 Stunde in Luft (45 % relative Luftfeuchte) gelagert. Nach dem Ausheizen und Entwickeln sind kaum Resistmuster zu erkennen und es befinden sich Resistrückstände auf und zwischen den Strukturen.

Beispiel 2

Eine Photoresistlösung wird aus 10 Teilen Tris-(4-t-butoxicarbonyloxiphenyl)sulfonium-trifluoromethansulfonat, 90 Teilen Poly-(p-vinylphenol-co-p-t-butoxicarbonyloxi-styrol) und 300 Teilen Cyclohexanon hergestellt. Die Lösung wird anschließend durch ein Filter mit einem Porendurchmesser von 0,2 µm filtriert.

Diese Resistlösung wird auf einem Siliziumwafer in einer Schichtdicke von ca. 1 µm aufgebracht und 1 Minute bei 100°C auf einer Heizplatte ausgeheizt. Dann belichtet man bildmäßig durch eine strukturierte Testmaske im Kontaktverfahren während 3 Sekunden mit Excimer-Laserlicht der Wellenlänge 248 nm.

Dann läßt man den Wafer 1 Stunde in trockener Stickstoffatmosphäre liegen, heizt anschließend bei 100°C 1 Minute aus und entwickelt. Das Resistmuster läßt sich ohne Lackrückstände entwickeln und es entstehen Resistmuster guter Qualität mit steilen Flanken.

Vergleichsbeispiel 2

Es wird wie in Beispiel 2 verfahren, jedoch wird der zur Lagerung verwendete Stickstoff durch ein Wasserbad geführt, so daß eine wassergesättigte Stickstoffatmosphäre resultiert. Bereits nach einer Lagerzeit von 5 Minuten lassen sich die Resistmuster nicht mehr einwandfrei entwickeln.

Beispiele 3 bis 6

Es wird wie in Beispiel 2 verfahren, jedoch wird anstatt der trockenen Stickstoffatmosphäre in trockenem Argon (3), Helium (4), Kohlendioxid (5) bzw. Sauerstoff (6) gelagert. Die Resistmuster lassen sich ebenfalls wie in Beispiel 2 rückstandsfrei entwickeln.

Beispiel 7

Es wird wie in Beispiel 2 verfahren, jedoch wird in Luft bei einer relativen Luftfeuchtigkeit von 40 % gelagert. Bis zu Lagerzeiten von 22 Minuten sind die Wafer noch einwandfrei entwickelbar, während Vergleichswafer, welche in Luft von relativer Luftfeuchtigkeit von 50 % gelagert werden, bereits nach Lagerzeiten > 5 Minuten Rückstände auf dem Wafer zeigen.

Vergleichsbeispiel 3

Es wird eine Photoresistlösung aus 10 Teilen Dimethyl-4-t-butoxicarbonyloxiphenylsulfoniumhexafluoroarsenat, 90 Teilen Poly-(vinylphenol-co-p-t-amyloxicarbonyloxi-styrol) und 300 Teilen Ethyllactat hergestellt und durch ein Filter mit einer Porenweite von 0,2 µm filtriert.

Die Resistlösung wird in einer Schichtdicke von ca. 1 µm auf einen Wafer aufgebracht und bildmäßig belichtet.

Lagert man anschließend in mit Ammoniak gesättigter Luft, so sind die Resistmuster bereits nach Lagerzeiten > 2 Minuten nicht mehr entwickelbar.

**Patentansprüche**

1. Verfahren zur Herstellung von Reliefmustern und Reliefbildern, bei dem man ein lichtempfindliches Beschichtungsmaterial, welches ein strahlungsempfindliches Gemisch, das

a) ein in Wasser unlösliches, in wäßrig-alkalischen Lösungen lösliches oder zumindest dispergierbares Bindemittel und

b) eine organische Verbindung, deren Löslichkeit in einem wäßrigalkalischen Entwickler durch Einwirkung von Säure erhöht wird und die mindestens eine durch Säure spaltbare Gruppierung, sowie zusätzlich eine weitere Gruppierung, die unter der Einwirkung von Strahlung eine starke Säure erzeugt, enthält,

auf ein Substrat aufbringt, das lichtempfindliche Material in einem gewünschten Muster mit elektromagnetischer Strahlung bildmäßig belichtet, nach der Belichtung bei Temperaturen zwischen 60°C und 120°C ausheizt, und anschließend das Muster mit einem basischen Entwickler entwickelt, dadurch gekennzeichnet, daß zwischen Belichtung und Ausheizen nach der Belichtung das Eindringen von Wasser und/oder anderer Nucleophiler in die Schicht reduziert oder vermieden wird, indem man sie nach der Belichtung in einer Atmosphäre mit relativer Luftfeuchte < 45 %, im Vakuum oder unter Inertgas lagert.

**2.** Verfahren nach Anspruch 1, dadurch gekennzeichnet, daß die organische Verbindung (b) als durch Säure spaltbare Gruppierung t-Butylcarbonat-, t-Amylcarbonat- oder t-Butylestergruppierungen enthält.

**3.** Verfahren nach Anspruch 1 oder 2, dadurch gekennzeichnet, daß man in einer Atmosphäre mit relativer Luftfeuchte < 40 % lagert.

**4.** Verfahren nach Anspruch 1 oder 2, dadurch gekennzeichnet, daß man nach der Belichtung im Vakuum lagert.

**5.** Verfahren nach Anspruch 1 oder 2, dadurch gekennzeichnet, daß man in trockener Inertgasatmosphäre lagert.

**6.** Verfahren nach Anspruch 1, 2 oder 5, dadurch gekennzeichnet, daß als Inertgas Argon, Stickstoff, Kohlendioxid bzw. Helium verwendet werden.

**7.** Verfahren nach einem der vorhergehenden Ansprüche, dadurch gekennzeichnet, daß als organische Verbindungen (b) Sulfoniumsalze der allgemeinen Formel (I)

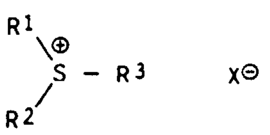

(I)

worin $R^1$, $R^2$ und $R^3$ untereinander gleich oder verschieden sind und für aliphatische und/oder aromatische Reste, die gegebenenfalls Heteroatome enthalten, stehen oder zwei der Reste $R^1$ bis $R^3$ miteinander zu einem Ring verknüpft sind, mit der Maßgabe, daß mindestens einer der Reste $R^1$ bis $R^3$ mindestens eine durch Säure spaltbare Gruppierung, vorzugsweise t-Butylcarbonate von Phenolen bzw. Silylether von Phenolen enthält, wobei einer der Reste $R^1$ bis $R^3$ mit einem oder mehreren weiteren Sulfoniumsalzresten, gegebenenfalls über durch Säure spaltbare Gruppierungen, verknüpft sein kann und $X^{\ominus}$ ein nichtnucleophiles Gegenion bedeutet, eingesetzt werden.

## Claims

**1.** A process for producing relief patterns and images in which a light-sensitive coating material which contains a radiation-sensitive mixture comprising

a) a water-insoluble but alkali-soluble or at least -dispersible binder and
b) an organic compound whose solubility in aqueous alkali is increased by the action of an acid and which contains at least one acid-cleavable group and additionally a group which forms a strong acid on irradiation

is applied to a substrate, the light-sensitive material is subjected to imagewise exposure to electromagnetic radiation in a desired pattern and, after exposure, heated to 60-120°C, and then the pattern is developed with a basic developer, which comprises reducing or avoiding the ingress of water and/or other nucleophiles into the layer between irradiation and postirradiation bake by storing the layer after irradiation in an atmosphere with a relative

humidity of < 45%, under reduced pressure or under an inert gas.

2. A process as claimed in claim 1, wherein the acid-cleavable group of the organic compound (b) is a t-butyl carbonate, t-amyl carbonate or t-butyl ester group.

3. A process as claimed in claim 1 or 2, wherein the relative humidity of the storage atmosphere is < 40%.

4. A process as claimed in claim 1 or 2, wherein the irradiated layer is stored under reduced pressure.

5. A process as claimed in claim 1 or 2, wherein the layer is stored in a dry inert gas atmosphere.

6. A process as claimed in claim 1, 2 or 5, wherein the inert gas used is argon, nitrogen, carbon dioxide or helium.

7. A process as claimed in any one of the preceding claims, wherein the organic compound (b) is a sulfonium salt of the formula (I)

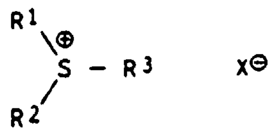

(I)

where $R^1$, $R^2$ and $R^3$ are identical or different and each is an aliphatic or aromatic radical which may contain hetero atoms or two of $R^1$ to $R^3$ form a ring, with the proviso that at least one of $R^1$ to $R^3$ contains at least one acid-cleavable group, preferably a t-butyl carbonate of phenol or a silyl ether of phenol, while one of $R^1$ to $R^3$ can be linked to one or more further sulfonium salt radicals, where appropriate via an acid-cleavable group, and $X^{\ominus}$ is a nonnucleophilic counter-ion.

## Revendications

1. Procédé de fabrication de motifs en relief et d'images en relief, dans lequel on applique sur un substrat un matériau de revêtement photosensible, contenant un mélange sensible au rayonnement, contenant

   a) un solvant insoluble dans l'eau, soluble ou au moins dispersable dans des solutions aqueuses-alcalines, et

   b) un composé organique, dont la solubilité dans un révélateur aqueux-alcalin est augmentée par l'effet d'un acide et qui contient au moins un groupe dispersable par un acide ainsi qu'en plus un autre groupe produisant un acide fort sous l'effet d'un rayonnement,

   on expose à la lumière le matériau photosensible selon un motif souhaité, pour produire une image avec un rayonnement électromagnétique, on chauffe après exposition à des températures comprises entre 60° et 120°C, puis l'on développe le motif avec un révélateur basique, caractérisé par le fait qu'entre l'exposition à la lumière et le chauffage, après exposition, la pénétration de l'eau et/ou d'autres produits nucléophiles dans la couche est réduite ou évitée, du fait qu'on le stocke après illumination dans une atmosphère d'une humidité relative < 45 %, sous vide ou dans un gaz inerte.

2. Procédé selon la revendication 1, caractérisé par le fait que le composé organique (b) contient, à titre de groupes dissociables par un acide, des groupes t-butylcarbonate, t-amylcarbonate ou t-butylester.

3. Procédé selon la revendication 1 ou la revendication 2, caractérisé par le fait que l'on effectue le stockage sous une atmosphère d'humidité relative < 45 %.

4. Procédé selon la revendication 1 ou 2, caractérisé par le fait qu'après exposition, on effectue le stockage sous vide.

5. Procédé selon la revendication 1 ou 2, caractérisé par le fait qu'on effectue le stockage sous une atmosphère de gaz inerte sèche.

6. Procédé selon la revendication 1, 2 ou 5, caractérisé par le fait qu'on utilise comme gaz inerte l'argon, l'azote, le dioxyde de carbone ou l'hélium.

7. Procédé selon l'une des revendications précédentes, caractérisé par le fait qu'on utilise, comme composés organiques (b), des sels de sulfonium de formule générale (I)

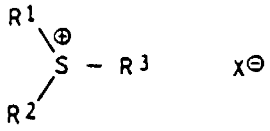

(I)

dans laquelle $R^1$, $R^2$ et $R^3$ sont identiques entre eux ou différents et sont des résidus aliphatiques et/ou aromatiques, contenant le cas échéant des hétéro-atomes ou bien deux résidus $R^1$ à $R^3$ sont combinés ensemble pour former un anneau, avec la condition qu'au moins l'un des résidus $R^1$ à $R^3$ contienne au moins un groupe dissociable par un acide, de préférence un t-butylcarbonate de phénols ou de silyléther de phénols, l'un des résidus $R^1$ à $R^3$ pouvant être combiné à un ou plusieurs autres résidus de sels sulfonium, le cas échéant par des groupes dissociables par un acide, et $X^{\ominus}$ étant un ion conjugué non nucléophile.